# EUROPÄISCHE PATENTSCHRIFT

(11) **EP 2 765 665 B1**
(45) Veröffentlichungstag und Bekanntmachung des Hinweises auf die Patenterteilung: **17.05.2017**
(21) Anmeldenummer: 14152581.6
(22) Anmeldetag: 27.01.2014
(51) Int. Cl.: H02H 3/33, G01R 19/10, G01R 15/18, H01F 27/42, H02H 1/00

(54) **Vorrichtung zur Erfassung von elektrischen Differenzströmen, insbesondere von Mischströmen aus glattem Gleichstrom und Wechselströmen**
Device for detecting differential currents, in particular of mixed currents of smoothed direct current and alternating currents
Dispositif de détection de courants électriques différentiels, notamment de courants mélangés constitués de courant continu lisse et de courants alternatifs

(30) Priorität: 09.02.2013 DE 102013002376
(43) Veröffentlichungstag der Anmeldung: 13.08.2014
(73) Patentinhaber: Doepke Schaltgeräte GmbH, 26506 Norden (DE)
(72) Erfinder: Grünebast, Günter, 26506 Norden (DE); Roolfs, Gerold, 26529 Upgant-Schott (DE); Bandy, Stefan, 26759 Hinte (DE); Schmidt, Robert, 26759 Hinte (DE)
(74) Vertreter: Jabbusch, Matthias

(56) Entgegenhaltungen:
- EP-A1- 0 356 248
- EP-A1- 0 499 589
- EP-A2- 0 005 694
- EP-A2- 1 267 467
- DE-A1- 3 728 912
- DE-A1- 19 705 767
- DE-U1- 29 506 883
- US-A1- 2014 320 112

## Beschreibung

Die Erfindung betrifft eine Vorrichtung zum Erfassen von elektrischen Differenzströmen, insbesondere von Mischströmen aus glattem Gleichstrom und Wechselströmen, umfassend wenigstens zwei Leiter für zu überwachende Lastströme und umfassend eine als Rechteckgenerator ausgebildete Schwingschaltung welche einen Stromwandler und zumindest zwei Sekundärwicklungen aufweist, wobei die Leiter durch den Stromwandler geführt sind.

Differenzstrom-Schutzeinrichtungen werden beispielsweise zum Personenschutz und zum Schutz elektrischer Anlagen eingesetzt, indem sie die vektorielle Summe der in die Anlage hineinfließenden Ströme, den Differenzstrom, erfassen und, falls dieser einen Grenzwert überschreitet, eine Trennung der Anlage vom Versorgungsnetz bewirken. Beim Einsatz von Frequenzumrichtern, PV-Wechselrichtern sowie beim Laden von Elektrofahrzeugen können in elektrischen Anlagen sowohl im Fehlerfall als auch betriebsbedingt durch Abfluss zur Erde Differenzströme im Frequenzbereich von 0 Hz (glatter Gleichfehlerstrom) bis zu mehreren kHz entstehen, die nur von allstromsensitiven Differenzstrom-Schutzeinrichtungen erfasst werden können. Vorrichtungen zum Erfassen von Differenzströmen mit einem Frequenzspektrum von 0 Hz bis zu mehreren kHz sind als allstromsensitive Differenzstrom-Schutzeinrichtungen aus dem Stand der Technik bekannt.

Allstromsensitive Differenzstrom-Schutzeinrichtungen vom Typ B oder Typ B+ sind zur Realisierung von Schutzmaßnahmen zum Schutz gegen elektrischen Schlag und zum zusätzlichen Schutz geeignet. Sie weisen Bemessungsdifferenzströme ≥ 30 mA auf. Aufgrund der einschlägigen Produktnormen darf eine allstromsensitive Differenzstrom-Schutzeinrichtung mit einem Bemessungsfehlerstrom von 30 mA bei Auftreten eines glatten Gleichfehlerstromes nicht unterhalb des halben Bemessungsfehlerstromes, also nicht unterhalb von 15 mA, aber maximal mit dem zweifachen Wert des Bemessungsfehlerstromes - also 60 mA - auslösen.

Pulsstromsensitive Differenzstrom-Schutzeinrichtungen vom Typ A werden üblicherweise in Hausinstallationen und ähnlichen Anwendungen eingesetzt und sind daher sehr weit verbreitet. Gegenüber einer allstromsensitiven Differenzstrom-Schutzeinrichtung erfassen sie nur Wechsel- und pulsierende Gleichfehlerströme der Netzfrequenz (z.B. 50 oder 60 Hz). Aufgrund einschlägiger Produktnormen dürfen pulsstromsensitive Differenzstrom-Schutzeinrichtungen vom Typ A jedoch unabhängig vom Bemessungsfehlerstrom mit einem glatten Gleichfehlerstrom von nur maximal 6 mA beaufschlagt werden. Es besteht die Gefahr, dass der Summenstromwandler der Differenzstrom-Schutzeinrichtungen vom Typ A aufgrund eines glatten Gleichfehlerstromes > 6 mA unzulässig vormagnetisiert wird, wodurch eine einwandfreie Funktion nicht mehr gewährleistet ist. Somit darf in einer elektrischen Anlage einer pulsstromsensitiven Differenzstrom-Schutzeinrichtung vom Typ A eine allstromsensitive Differenzstrom-Schutzeinrichtung vom Typ B oder Typ B+ nicht nachgeschaltet werden. Wenn nun also eine allstromsensitive Differenzstrom-Schutzeinrichtung einer pulsstromsensitiven Differenzstrom-Schutzeinrichtung in unzulässiger Weise nachgeschaltet wäre, dann würde die pulsstromsensitive Differenzstrom-Schutzeinrichtung im ungünstigsten Fall mit 60 mA vorbelastet werden, also mit dem 10-fachen des zulässigen Wertes.

Dieses ist jedoch nachteilig, weil allstromsensitive Differenzstrom-Schutzeinrichtungen vom Typ B oder Typ B+ oft in mobilen mit Steckvorrichtungen ausgestatteten Einheiten, z.B. in Baustromverteilern oder Ladeeinrichtungen für Elektro-Fahrzeuge eingesetzt werden. Diese Einheiten können auch von elektrotechnischen Laien bedient und an einem beliebigen geeigneten Übergabepunkt (Steckdose) angeschlossen werden, wobei eine möglicherweise für diesen Übergabepunkt vorhandene festinstallierte Schutzeinrichtung unbekannt ist. Von einem elektrotechnischen Laien kann nicht erwartet werden, dass er sich mit möglicherweise installierten Schutzeinrichtungen auskennt. Wenn nun dieser Übergabepunkt mit einer pulsstromsensitiven Differenzstrom-Schutzeinrichtung vom Typ A geschützt ist, besteht im Fehlerfall die Gefahr, dass diese Schutzeinrichtung mit einem glatten Gleichfehlerstrom > 6 mA beaufschlagt wird und möglicherweise weitere Fehler in anderen durch dieselbe Schutzeinrichtung geschützten Stromkreisen nicht mehr einwandfrei erfasst werden.

Es wäre daher vorteilhaft, wenn eine Differenzstrom-Schutzeinrichtung auch glatte Gleichfehlerströme ≤ 6 mA zuverlässig erfassen kann, so dass eine Abschaltung bei Auftreten eines glatten Gleichfehlerstromes von maximal 6 mA erfolgt. Dadurch kann diese Differenzstrom-Schutzeinrichtung in vorteilhafter Weise problemlos einer pulsstromsensitiven Differenzstrom-Schutzeinrichtung nachgeschaltet werden, weil eine vorgeschaltete pulsstromsensitive Differenzstrom-Schutzeinrichtung auch im ungünstigsten Fall nicht unzulässig mit einem glatten Gleichfehlerstrom > 6 mA vorbelastet wird. Eine elektrische Einheit (z.B. ein Baustromverteiler oder eine Ladeeinrichtung für ein Elektro-Fahrzeug), die mit der hier vorgeschlagenen Differenzstrom-Schutzeinrichtung ausgestattet ist, kann somit auch von einem elektrotechnischem Laien bedient und an einem beliebigen Übergabepunkt (Steckdose) angeschlossen werden, auch wenn eine möglicherweise vorgeschaltete weitere Schutzeinrichtung unbekannt ist. Besonders vorteilhaft ist es, wenn die vorgeschlagene Differenzstrom-Schutzeinrichtung allstromsensitiv ist, da diese i.d.R. eine breitbandige Erfassung von Differenzströmen erlaubt und somit den größten Schutzumfang bietet.

Auch eine umgekehrte Verschaltung der oben aufgeführten Differenzstrom-Schutzeinrichtungen wäre problemlos möglich. Das heißt, einer Differenzstrom-Schutzeinrichtung, welche auch glatte Gleichfehlerströme ≤ 6 mA zuverlässig erfassen kann, dürfte auch eine pulsstromsensitive Differenzstrom-Schutzeinrichtung vom Typ A elektrisch nachgeschaltet werden.

In vielen europäischen Ländern werden in Hausinstallationen und ähnlichen Anwendungen an Stelle einer Differenzstrom-Schutzeinrichtung vom Typ A solche vom Typ AC eingesetzt. Wechselstromsensitive Differenzstrom-Schutzeinrichtungen vom Typ AC erfassen nur Wechselfehlerströme der Netzfrequenz (z.B. 50 Hz oder 60 Hz) und können durch glatte Gleichfehlerströme aber auch durch hohe Differenzströme mit höherfrequenten Anteilen in ihrer Funktion erheblich beeinträchtig oder sogar zerstört werden. Es wäre daher vorteilhaft, wenn die vorgeschlagene Differenzstrom-Schutzeinrichtung nicht nur glatte Gleichfehlerströme ≤ 6 mA zuverlässig erfassen kann, sondern auch eine breitbandige Erfassung aufweist, um auch bei höherfrequenten Differenzströmen eine sichere Auslösung zu erzielen, sodass diese Differenzstrom-Schutzeinrichtung auch einer wechselstromsensitiven Differenzstrom-Schutzeinrichtung vom Typ AC nach- oder vorgeschaltet werden kann.

Zudem sind auch Differenzstrom-Schutzeinrichtungen vom Typ F am Markt verfügbar. Diese dürfen im Gegensatz zu Differenzstrom-Schutzeinrichtungen vom Typ A mit einem glatten Gleichfehlerstrom von maximal 10 mA beaufschlagt werden.

In einigen Anwendungsfällen kann es ausreichend sein, dass die erfindungsgemäße Vorrichtung so ausgestaltet ist, dass nur Wechselfehlerströme und pulsierende Gleichfehlerströme der Netzfrequenz sowie glatte Gleichfehlerströme erfasst werden und dass eine Auslösung bei glatten Gleichfehlerströmen ≤ 6 mA erfolgt. Beispielsweise sind bei der Ladung von Elektrofahrzeugen im Fehlerfall keine Frequenzanteile zwischen 0 Hz und der Netzfrequenz (üblicherweise 50 Hz oder 60 Hz) zu erwarten. Daher kann hier ggf. zur Kosteneinsparung auf eine breitbandige Erfassung verzichtet werden.

Wie bereits weiter oben erwähnt, sind aus dem Stand der Technik allstromsensitive Fehlerstrom-Schutzeinrichtungen bekannt, also Fehlerstrom-Schutzeinrichtungen, die sowohl glatte Gleichfehlerströme als auch pulsierende Gleichfehlerströme der Netzfrequenz und auch Wechselfehlerströme mit unterschiedlichen Frequenzen erfassen können. Eine einfache spannungsunabhängige Erfassung von glatten Gleichfehlerströmen nach dem bekannten Induktionsprinzip ist physikalisch nicht möglich. Daher wird zur Erfassung von glatten Gleichfehlerströmen üblicherweise das Prinzip der gesteuerten Induktivität verwendet, welches spannungsabhängig ist.

Aus dem Stand der Technik ist nach EP 1267467 eine Vorrichtung zur breitbandigen und verzerrungsfreien sowie signalgetreuen Erfassung von elektrischen Differenzströmen insbesondere von Mischströmen aus glattem Gleichstrom und Wechselströmen bekannt, wobei die zu überwachenden Leiter durch zwei magnetische Stromwandler geführt sind und wobei der zweite Stromwandler mit dem ersten Stromwandler verschaltet ist und auf dem Leitungsweg zwischen den Stromwandlern ein eine Phasendrehung des über den Leitungsweg geführten Stromes um etwa 180 DEG bewirkendes Koppelglied angeordnet ist, das als Hochpass ausgbildet ist. Diese Vorrichtung erlaubt den Aufbau einer aus dem Stand der Technik bekannten allstromsensitiven Differenzstrom-Schutzeinrichtung vom Typ B oder B+.

Die Vorrichtung nach EP 1267467 sowie weitere bekannte Vorrichtungen der gleichen Gattung sind jedoch nicht zur zuverlässigen Erfassung von sehr kleinen glatten Gleichfehlerströmen z.B. ≤ 6 mA geeignet. Bei der Vorrichtung nach EP 1267467 ist zur Erfassung von glatten Gleichfehlerströmen vorgesehen, dass die Schaltung und eine Sekundärwicklung eines ersten Stromwandlers Bestandteil einer als Rechteckgenerator ausgebildeten Schwingschaltung sind. Diese Art der Schaltung, welche nach dem Prinzip der gesteuerten Induktivität funktioniert, ist im Stand der Technik bekannt. Es ist weiterhin bekannt, dass aufgrund der Konstruktion mit nur einer Sekundärwicklung des ersten Stromwandlers auch ohne vorhandenem Fehlerstrom durchaus DC-Offsetströme > 6 mA bedingt durch unerwünschte Bauteiltoleranzen insbesondere der Schwingschaltung über einen weiten Temperaturbereich zu erwarten sind, so dass eine Erfassung von glatten Gleichfehlerströmen ≤ 6 mA auf zuverlässige Weise daher nicht möglich ist. Zudem sind bisher allstromsensitive Differenzstrom-Schutzeinrichtungen mit Bemessungsfehlerströmen < 30 mA normativ nicht vorgesehen, so dass solche Schaltungen der oben erwähnten Art bislang nicht zur Erfassung sehr kleiner glatter Gleichfehlerströme erforderlich sind.

Aus der JP 2012 002723 A ist eine gattungsgemäße Vorrichtung zum Erfassen mit Stromwandler bekannt. In der EP 0 005 694 A2 sind dagegen Multivibratoren vorgeschlagen worden, weiterhin über einen Widerstand in Serie geschaltete Sekundärwicklungen.

Der Erfindung liegt daher die Aufgabe zugrunde, eine Vorrichtung der eingangs genannten Gattung aufzuzeigen, welche einer beliebigen Differenzstrom-Schutzeinrichtung elektrisch nach- oder vorgeschaltet werden kann, wobei eine unzulässig hohe Beaufschlagung mit glatten Gleichfehlerströmen zuverlässig verhindert wird, so dass eine beliebige Differenzstrom-Schutzeinrichtung in ihrer bestimmungsgemäßen Funktion aufgrund unzulässig hoher glatter Gleichfehlerströme nicht beeinträchtigt wird.

Diese Aufgabe wird erfindungsgemäß dadurch gelöst, dass die Sekundärwicklungen des Stromwandlers mit zumindest einem ohmschen Widerstand elektrisch in Reihe verschaltet sind, dass die Schwingschaltung zwei Operationsverstärker aufweist, welche mit jeweils einer Sekundärwicklung verschaltet sind und dass die Ausgänge der Operationsverstärker mit den Eingängen einer Differenzverstärkerschaltung verschaltet sind.

In der erfindungsgemäßen Vorrichtung ist vorgesehen, dass zur Erfassung sehr kleiner glatter Gleichfehlerströme der erste Stromwandler zumindest zwei Sekundärwicklungen aufweist und wobei der Stromwandler mit zwei Sekundärwicklungen sowie zwei Operationsverstärker Bestandteile einer als Rechteckgenerator ausgebildeten Schwingschaltung sind. Abweichend zur Schwingschaltung aus EP 1267467 weist die hier vorgesehene erfinderisch als Brückenschaltung ausgeführte Schwingschaltung erheblich geringere unerwünschte parasitäre Eigenschaften auf, wie z.B. einen bauteilbedingten und temperaturabhängigen unerwünschten DC-Offset. Bei der aus EP 1267467 bekannten Schwingschaltung ändern sich die positive und negative Ausgangsspannung des Operationsverstärkers der Schwingschaltung nicht im gleichen Maße in Abhängigkeit der Temperatur, so dass sich ein unerwünschter temperaturabhängiger DC-Offset einstellt, welcher von einer nachfolgenden Auswerteschaltung irrtümlicherweise als DC-Fehlerstrom interpretiert wird. Diese Rechteck-Schwingschaltung weist nur dann keinen unerwünschten DC-Offset auf, wenn die positive und die negative Ausgangsspannung des Operationsverstärkers gleich sind.

Bei der hier vorgesehenen erfinderischen Ausgestaltung sind zwei Sekundärwicklungen des ersten Stromwandlers zusammen mit einem ohmschen Widerstand quasi in Reihe angeordnet. Eine Hälfte dieser als Brückenschaltung ausgebildeten Schwingschaltung ist zur Steuerung der positiven, die andere Hälfte zur Steuerung der negativen Halbwelle der Rechteckschwingung vorgesehen. Ändern sich nun beispielsweise temperaturbedingt die Ausgangsspannungen der beiden Operationsverstärker, so ändern sich auch die durch die beiden Widerstandsteiler bestimmten Kipppunkte im gleichen Maße, so dass die Flächeninhalte der positiven und negativen Halbwelle des Rechtecksignals gleich sind und so kein unerwünschter DC-Offset entsteht. In besonders vorteilhafter Weise sind beide Operationsverstärker in einem Gehäuse angeordnet, sodass thermisch bedingte Änderungen der Ausgangsspannungen beider Operationsverstärker immer gleich sind. Gehäuse von Doppel-Operationsverstärkern weisen meist die gleichen Abmessungen wie Gehäuse von Einfach-Operationsverstärker auf. Zudem sind Doppel-Operationsverstärker i.d.R. kaum teurer als Einfach-Operationsverstärker. Somit lässt sich die hier vorgesehene erfinderische Ausgestaltung im Vergleich zur Schwingschaltung aus EP 1267467 kostengünstig und ohne erhöhten Platzbedarf realisieren. Die Ausgänge beider Operationsverstärker können eingangsseitig mit einer Differenzverstärkerschaltung verschaltet sein, sodass am Ausgang der Differenzverstärkerschaltung ein zur einfachen Weiterverarbeitung massebezogenes Spannungssignal zur Verfügung steht.

Nach der Erfindung ist die erfindungsgemäße Vorrichtung für besondere Anwendungsfälle nur zur Erfassung von Wechselfehlerströmen und pulsierenden Gleichfehlerströmen der Netzfrequenz sowie zur Erfassung von glatten Gleichfehlerströmen vorgesehen, wobei eine Auslösung bei glatten Gleichfehlerströmen ≤ 6 mA erfolgt. Zu diesem Zweck umfasst die Vorrichtung zumindest eine wie weiter oben beschriebene Schwingschaltung mit einem Stromwandler mit zumindest zwei Sekundärwicklungen sowie zwei Operationsverstärker die Bestandteil dieser Schwingschaltung sind zur Erfassung von glatten Gleichfehlerströmen ≤ 6 mA. Zudem umfasst die Vorrichtung zumindest einen weiteren Summenstromwandler sowie eine hilfsspannungsunabhängige Auswerteschaltung zur Erfassung von Wechselfehlerströmen und pulsierenden Gleichfehlerströmen der Netzfrequenz. Dadurch reduziert sich ebenfalls die Leistungsaufnahme der Vorrichtung erheblich, so dass die erforderliche Netzteilschaltung zur Versorgung der Schaltungen zur Erfassung von glatten Gleichfehlerströmen erheblich kostengünstiger und kleiner ausgeführt sein kann.

In einer Weiterbildung der Erfindung ist vorgesehen, dass die Schwingung der Schwingschaltung überwacht wird. Bei sehr hohen Differenzströmen besteht die Gefahr eines unerwünschten Schwingungsstillstandes, weil der magnetische Kern des Stromwandlers der Schwingschaltung aufgrund der hohen Durchflutung magnetisch stark gesättigt wird und so eine zuverlässige Auswertung der Differenzströme nicht mehr erfolgen kann. Zu diesem Zweck ist vorgesehen, dass eine Überwachungsschaltung bei einem unerwünschten Stillstand der Schwingschaltung ein Ausgangssignal bereitstellt, welches zur sofortigen Abschaltung der erfindungsgemäßen Vorrichtung führt.

In einer weiteren Ausgestaltung der Erfindung ist vorgesehen, dass die Erfassung und Auswertung von Wechselfehlerströmen mit Frequenzen > 0 Hz hilfsspannungsunabhängig erfolgt, wobei sowohl Wechselfehlerströme mit sehr niedrigen Frequenzen (z.B. der Netzfrequenz und auch darunter) als auch mit sehr hohen Frequenzen (z.B. 100 kHz) erfasst werden können. Zu diesem Zweck weist die Sekundärwicklung des zweiten Stromwandlers eine deutlich höhere Windungszahl auf, so dass diesem Stromwandler nachfolgend eine aus dem Stand der Technik bekannte als Energiespeicherschaltung bezeichnete Schaltung angeordnet sein kann. Bei dieser Ausgestaltung werden weniger Baugruppen und somit weniger Bauteile benötigt. In vorteilhafter Weise kann dadurch die Leistungsaufnahme der Vorrichtung erheblich reduziert werden, so dass die erforderliche Netzteilschaltung zur Versorgung der Schaltungen zur Erfassung und Auswertung von glatten Gleichfehlerströmen erheblich kostengünstiger und kleiner ausgeführt sein kann.

Eine solche Energiespeicherschaltung ist z.B. aus DE 10201101984 bekannt. Mit dieser Schaltung lassen sich hilfsspannungsunabhängig in einfacher Weise Differenzströme breitbandig bis zu sehr hohen Frequenzen (z.B. 100 kHz) erfassen. Sie besteht üblicherweise eingangsseitig aus einer Schaltung zur Spannungsvervielfachung, wobei die Schaltung zur Spannungsvervielfachung eingangsseitig ein als ohmschen Widerstand ausgeführtes Bauteil aufweisen kann, mit welchem sich das Verhalten bezüglich der Erfassung und Auswertung verschiedener Frequenzanteile sowie Stromkurvenformen im Differenzstrom beeinflussen lässt. Mit diesem ohmschen Widerstand elektrisch verschaltet ist die Sekundärwicklung des Stromwandlers zur Erfassung von Wechselfehlerströmen. In besonders vorteilhafter Weise ist nun der bei Energiespeicherschaltungen übliche und erforderliche eingangsseitige ohmsche Widerstand erfindungsgemäß gleichzeitig ein Bestandteil des zwischen den Stromwandlern eine Phasendrehung des über den Leitungsweg geführten Stromes um etwa 180 DEG bewirkendes Koppelglied, welches als Hochpass ausgebildet ist.

Der Schaltung zur Spannungsvervielfachung ist elektrisch nachfolgend ein Speicherkondensator angeordnet. Die Höhe der Ladespannung des Speicherkondensators ist ein Maß für die Höhe des erfassten Differenzstromes. Die Ladespannung wird mit Hilfe einer nachfolgenden Komparatorschaltung mit einem Referenzwert verglichen. Wird dieser Wert überschritten, erfolgt eine Abschaltung der Vorrichtung mit Hilfe des Auslöserelais, welches auf ein mechanisches Schaltschloss wirkt, so dass die in den zu überwachenden Leitern angeordneten Schaltkontakte geöffnet werden.

Der Ausgang des Komparators der Auswerteschaltung zur Erfassung glatter Gleichfehlerströme ≤ 6 mA ist in vorteilhafter Weise mit dem Speicherkondensator der Auswerteschaltung zur Erfassung von Wechselfehlerströmen elektrisch verschaltet, so dass bei einem glatten Gleichfehlerstrom > 6 mA eine Abschaltung der Vorrichtung erfolgen kann.

Alternativ kann vorgesehen sein, dass das Ausgangssignal des Komparators der Auswerteschaltung zur Erfassung von Wechselfehlerströmen aus der erfindungsgemäßen Vorrichtung herausgeführt wird, so dass dieses Signal anderen elektrischen Betriebsmitteln bereitgestellt werden kann. Beispielsweise kann eine Steuereinheit eines elektrischen Betriebsmittels (z.B. eines Frequenzumrichters) dann eine Abschaltung des Betriebsmittels bewirken, sodass beispielsweise dieses Betriebsmittel im Fehlerfall keine glatten Gleichfehlerströme > 6 mA in die elektrische Anlage einspeisen kann.

In einer weiteren Ausgestaltung der Erfindung ist vorgesehen, dass alle Komponenten der erfindungsgemäßen Vorrichtung in einem gemeinsamen Gehäuse angeordnet sind. Dadurch kann die Vorrichtung beispielsweise als Fehlerstrom-Schutzschalter ohne eingebauten Überstromschutz (RCCB) oder mit eingebautem Überstromschutz (RCBO) bekannte Schutzeinrichtung in einfacher Weise zur Installation in elektrischen Anlagen vorgesehen werden.

In einer weiteren Ausgestaltung der Erfindung ist vorgesehen, dass die Summenstromwandler und die elektronischen Schaltungen und das Schaltschloss mit Schaltkontakten in unterschiedlichen Gehäusen angeordnet sind. Dadurch kann die Vorrichtung auch als RCM oder als CBR bzw. MRCD bekannte Schutzeinrichtung in modularer Form realisiert werden. Beispielsweise kann der Summenstromwandler in einem separaten Gehäuse angeordnet sein, während die elektronischen Schaltungen auf einer oder mehreren Leiterplatten angeordnet in einem elektrischen Betriebsmittel integriert sind. Es kann zudem ein Ausgangssignal bereitstellt werden, welches beispielsweise einer als µC ausgeführten Steuereinheit des elektrischen Betriebsmittels zur Verfügung gestellt wird. Die Steuereinheit kann dann eine Abschaltung der zu überwachenden Leitungen mit Hilfe einer Abschalteinrichtung bewirken, die Bestandteil des Betriebsmittels sein kann.

Ausführungsbeispiele der Erfindung, aus denen sich weitere erfinderische Merkmale ergeben, sind in der Zeichnung dargestellt. Es zeigen:
- Fig. 1:: ein Blockschaltbild einer allstromsensitiven Differenzstrom-Schutzeinrichtung nach dem Stand der Technik;
- Fig. 2:: eine erfindungsgemäße Schaltungsanordnung einer als Rechteckgenerator ausgebildeten Schwingschaltung;
- Fig. 3:: ein Blockschaltbild eines ersten Ausführungsbeispiels der erfindungsgemäßen Vorrichtung;
- Fig. 4:: ein Blockschaltbild eines zweiten Ausführungsbeispiels der erfindungsgemäßen Vorrichtung.

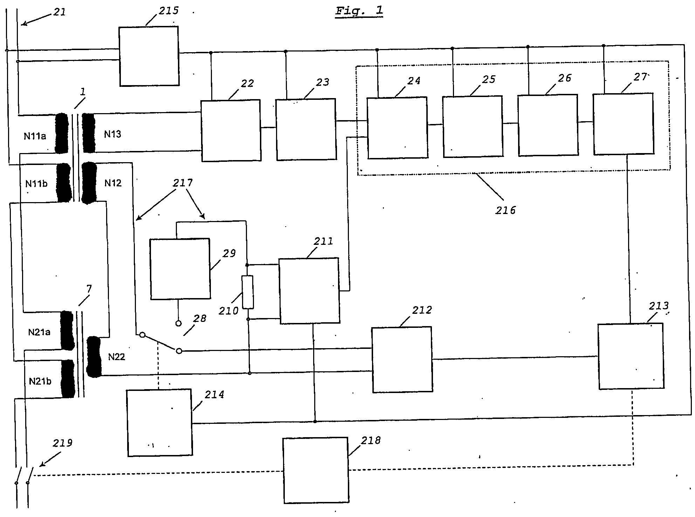

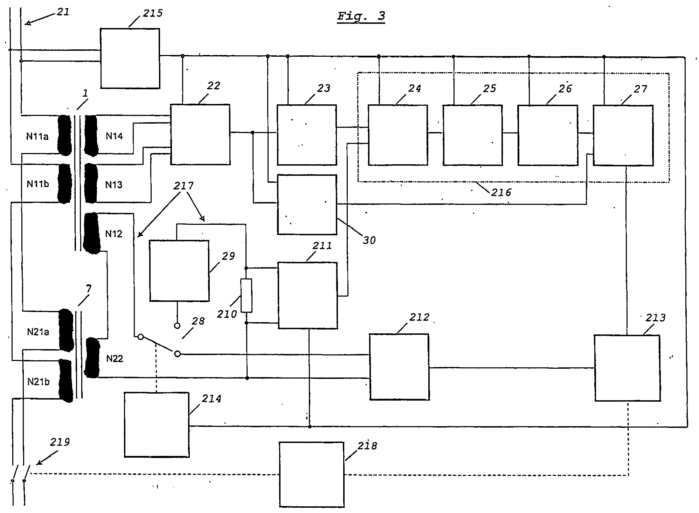

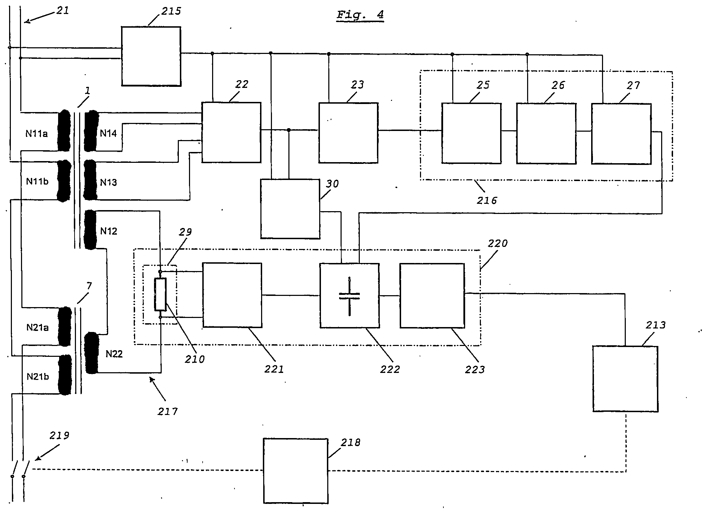

Fig. 1 zeigt zur Bezugnahme auf Fig. 3 und Fig. 4 zum besseren Verständnis aus der EP 1267467 das Blockschaltbild einer bekannten allstromsensitiven Differenzstrom-Schutzeinrichtung mit breitbandiger Erfassung. Die aufgezeigte Vorrichtung kann so ausgeführt sein, dass beliebig viele zu überwachende Leitungen 21 vorgesehen sind. Beispielhaft sind hier zwei zu überwachende Leitungen 21 mit in den zu überwachenden Leitungen 21 angeordneten Schaltkontakten 219 dargestellt. Die beispielhaft aufgezeigten Primärwicklungen N11a und N11b sowie N21a und N21b der Stromwandler 1 und 7 sind mit den zu überwachenden Leitungen 21 jeweils in Reihe verschaltet.

Zur Erkennung von glatten Gleichfehlerströmen sowie Wechselfehlerströmen mit niedrigen Frequenzen, welche nach dem Induktionsprinzip nicht erfasst werden können, wird eine Erfassung nach dem Prinzip der gesteuerten Induktivität im Stromwandler 1 vorgenommen. Um sicherzustellen, dass hierbei die Shannon'sche Abtastbedingung nicht durch Differenzstromanteile zu hoher Frequenzen verletzt wird, werden diese Stromanteile von dem zweiten Stromwandler 7 auf die Wicklung N12 des ersten Stromwandlers 1 gegengekoppelt, so dass sie magnetisch nur noch stark gedämpft im Kern des Stromwandlers 1 wirksam werden. Die Wicklungen N12 und N22 haben zu diesem Zweck vorzugsweise gleiche Windungszahlen und der Stromwandler 7 hat einen Kern mit einem wesentlich größeren Induktivitätsfaktor als der Kern des Stromwandlers 1. Hierdurch wirkt der Stromwandler 7 über seine Wicklung N22 auf die Wicklung N12 als Stromquelle, so dass der Vormagnetisierungsstrom nicht vom Stromwandler 1 auf den Stromwandler 7 übertragen wird. Ein Koppelglied 29 im Gegenkopplungsstromkreis 217 bestimmt dabei allein oder zusammen mit den Induktivitäten der Wicklungen N12 und N22 die Amplituden / Frequenz - Charakteristik des gegengekoppelten Stromes.

Stromanteile mit Frequenzen, die eine fehlerfreie Modulation des Trägersignals, also des Rechtecksignals der Schwingschaltung 22, stören, werden somit aus dem Differenzstromspektrum entfernt. Es ist ein in den Gegekopplungsstromkreis 217 geschalteter Strommesswiderstand 210, dem eine Verzögerungsschaltung 211 zur Ansprechverzögerung der höherfrequenten Differenzstromspektralanteile nachgeordnet ist, mit der Auswerteeinrichtung 216 verknüpft. An dem Strommesswiderstand 210 ist eine dem Gegenkopplungsstrom proportionale Spannung abgreifbar.

Da der Gegenkopplungsstrom die oberen Frequenzanteile des Differenzstromes mit dem Amplituden / Frequenz - Verlauf enthält, die im Wandler 1 aufgrund der Gegenkopplung ausgelöscht wurden, lassen sich die in beiden Signalwegen übertragenen Frequenzspektren nach einer Verstärkungsanpassung in idealer Weise wieder vollständig zu dem ursprünglichen Gesamtfrequenzspektrum des Differenzstromes addieren, was einem glatten Frequenzgang des Ansprechstromes der allstromsensitiven Differenzstrom-Schutzeinrichtung entspricht.

Der Stromwandler 1 ist mit einer Sekundärwicklung N13 Bestandteil einer modulierenden Schwingschaltung 22, die als Rechteckgenerator (Multivibrator) ausgebildet ist, wodurch eine einfache Wechsel-Vormagnetisierung des Stromwandlers 1 mit einem Wechselstrom einer hohen Trägerfrequenz ermöglicht wird. Zur Demodulation ist ein Tiefpassfilter 23 im Leitungsweg angeordnet ist. Um die Trägerfrequenz der Schwingschaltung 22 ausreichend zu unterdrücken, ist das Tiefpassfilter 23 beispielsweise als aktives Filter höherer Ordnung mit einer großen Steilheit im Sperrbereich und einer Grenzfrequenz deutlich unterhalb der Trägerfrequenz ausgebildet.

Die Auswerteeinrichtung 216 weist unter anderem zum Auswerten der Signale des unteren Frequenzspektrums aus dem Tiefpass 23 und der höherfrequenten vom Gegenkopplungsstrom abgeleiteten Signale einen Summierverstärker 24 mit nachfolgendem Zweiweggleichrichter 25 auf. Der Summierverstärker 24 ermöglicht, dass die auf zweifache Weise erfassten Differenzstromspektren durch unterschiedliche Verstärkung verschiedenen Bemessungsdifferenzströmen zugeordnet werden können. Beispielsweise werden zur Realisierung eines Personenschutzes mit einem Bemessungs-differenzstrom von 30 mA von dem ersten Stromwandler 1 nur Differenz-stromspektralanteile von 0 bis etwa 100 Hz separiert, während aus dem aus der Stromgegenkopplung generierten Signal weitere Differenzstromspektralanteile bis in den MHz-Bereich erfasst und zur Realisierung eines Brandschutzes einem Bemessungsdifferenzstrom von 300 mA zugeordnet werden. Dem Zweiweggleichrichter 25 ist ein Tiefpassfilter 26 und eine Komparatorschaltung 27 nachgeordnet ist. Mit dem Tiefpassfilter 26 kann eine Grenzfrequenz so eingestellt wird, dass der nachfolgende Komparator 27 auch auf Amplituden von 50 Hz Pulsdifferenzstromsignalen innerhalb der in den einschlägigen Normen geforderten Grenzen anspricht.

Die Komparatorschaltung 27 weist zwei nacheinander geschaltete Komparatoren auf, wobei dem zweiten Komparator ein Tiefpassfilter zugeordnet ist. Der zweite Komparator mit dem Tiefpassfilter dient dazu, dass die Vorrichtung bei kurzen transienten Differenzströmen nicht anspricht. Weiterhin wird mit der Tiefpassschaltung eine Verzögerung erreicht, welche ein Ansprechen erst bei der maximal zulässigen Auslösezeit bewirkt. Dadurch erhöht sich die Störsicherheit der Vorrichtung. Bei Ausführungen der Vorrichtung für Bemessungsdifferenzströme > 30 mA können somit Ansprechzeiten eingestellt werden, die der Vorrichtung eine Eigenschaft als zeitselektive Differenzstrom-Schutzeinrichtung geben. Schließlich kann die Komparatorschaltung 27 mit wenigstens einem Auslöserelais 213 verknüpft sein, das bei Vorlage eines unzulässig hohen Differenzstromes bewirkt, dass ein mechanisches Schaltschloss 218 die in den zu überwachenden Leitungen 21 angeordnet Schaltkontakte 219 öffnet, sodass der Stromfluss unterbrochen wird.

Das Auslöserelais 213 ist mit den Sekundärwicklungen N22, N12 der beiden Stromwandler 1, 7 verknüpfbar, wobei die Verknüpfung über einen Schaltkontakt 28 vorgenommen ist, welcher von zumindestens einem Unterspannungsdetektor 214 in schaltender Weise beaufschlagt ist. Der Schaltkontakt 28 kann mechanisch oder elektronisch ausgeführt sein. Die Vorrichtung ist dadurch auch in einem Unterspannungsbereich hilfsspannungsunabhängig wie ein herkömmlicher FI-Schutzschalter zur Erfassung von Differenzströmen in einem eingeschränkten Frequenzbereich einsetzbar. Liegt die für die hilfsspannungsabhängigen Baugruppen der Vorrichtung erforderliche Netzspannung unterhalb eines definierten Wertes, so werden die Sekundärwicklungen N22, N12 der beiden Stromwandler 1, 7 direkt mit der Erregerspule des Auslöserelais 213 verschaltet. Der Schaltkontakt 28 stellt die leitende Verbindung zwischen diesen Bauelementen her.

Das Koppelglied 29 ist in einfachster Weise als ohmscher Widerstand ausgeführt, der zusammen mit den Induktivitäten der Wicklungen N12 und N22 für den Strom im Gegenkopplungskreis 217 einen Hochpass erster Ordnung bildet.

Die in den zu überwachenden Leitern 21 angeordneten primären Wicklungen beider Stromwandler 1, 7 sind gemeinsame Wicklungen um beide magnetischen Kerne der Stromwandler 1, 7. Eine erste Sekundärwicklung N13 des ersten Stromwandlers 1 ist als separate Wicklung für die Schwingschaltung 22 ausgebildet und die Sekundärwicklung N22 des zweiten Stromwandlers 7 und eine zweite Sekundärwicklung N12 des ersten Stromwandlers 1 sind eine gemeinsame Wicklung. Hierdurch ist die erforderliche Phasendrehung für eine gegenkoppelnde Wirkung des Stromes aus der Wicklung N22 des Stromwandlers 7 auf den Stromwandler 1 mit einfachen passiven Zweipolen als Koppelglied gegeben.

Der Schaltkontakt 28 im Stromkreis der Sekundärwicklungen N12 und N22 steht mit dem Unterspannungsdetektor 214 in seine Schaltung bewirkender Wechselwirkung. Das Blockschaltbild zeigt den Zustand bei Vorlage einer Unterspannung. In diesem Fall sind die Sekundärwicklungen N12 und N22 beider Stromwandler 1, 7 über die elektrische Anpassschaltung 212 direkt mit dem Auslöserelais 213 verknüpft.

Eine Netzteilschaltung 215, welche aus den elektrischen Leitern 21 gespeist wird, versorgt die hilfsspannungsabhängigen Baugruppen 22, 23, 24, 25, 26, 27, 211 und 214 mit einer erforderlichen Gleichspannung.

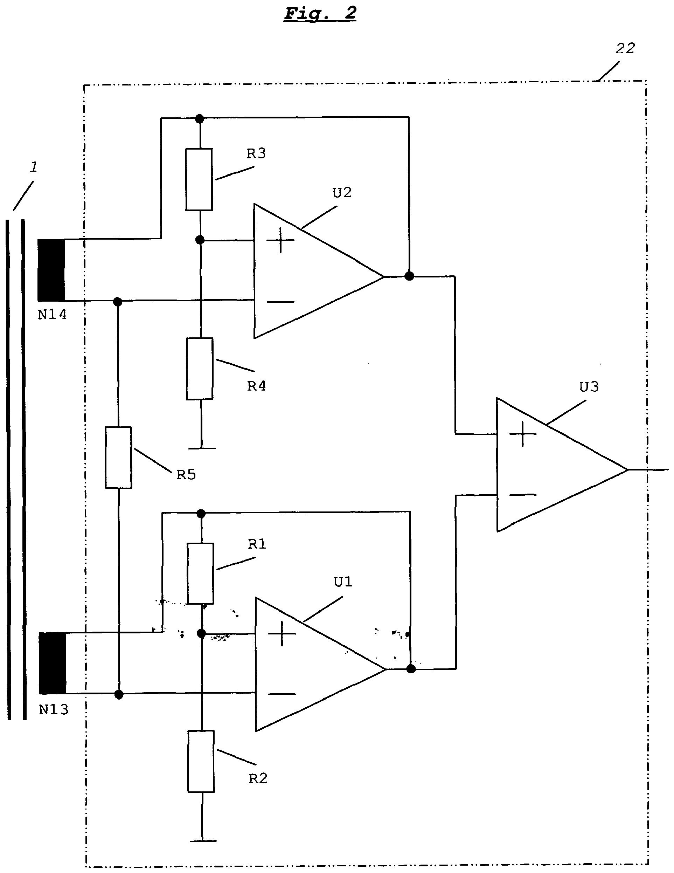

Fig. 2 zeigt ein Schaltbild einer erfindungsgemäßen Schaltung 22 mit 2 Sekundärwicklungen N13, N14 des Stromwandlers 1 dargestellt. Es zeigt eine Gestaltung der modulierenden Schwingschaltung als Multivibrator mit zwei Komparatoren oder Operationsverstärkern U1, U2. Hierbei sind die Induktivitäten der Sekundärwicklungen N13, N14 auf dem magnetischen Kern des ersten Stromwandlers 1 zusammen mit den ohmschen Widerständen R1, R2 und R3, R4 sowie R5 frequenzbestimmend.

Durch den die Wicklungen N13, N14 des Stromwandlers 1 durchfließenden Wechselstrom stellt sich in dessen magnetischen Kern ein wechselmagnetisierender Zustand ein. Wird der Stromwandler 1 von keinem weiteren Strom durchflutet, so ist das Ausgangssignal des Rechteckgenerators, welches als Differenzsignal gegenüber Masse an den beiden Ausgängen von U1, U2 abgegriffen wird, ein Rechtecksignal mit einem Puls-Pausenverhältnis von 1:1. Wird der Kern des Stromwandlers 1 jedoch zusätzlich durch einen Differenzstrom, d.h. durch eine Differenz der Lastströme in den primären Wicklungen N11a und N11b magnetisiert, so beeinflusst dieser Differenzstrom den wechselmagnetischen Zustand, welcher dem Verlauf des Differenzstromes entsprechend eine augenblickliche Veränderung der Induktivitäten der Wicklungen N13, N14 zur Folge hat. Damit ändert sich die Zeitkonstante des frequenzbestimmenden Gliedes, bestehend aus den Induktivitäten der Wicklungen N13, N14 und dem Widerstand R5, und somit das Puls-Pausenverhältnis der Rechteckgeneratorschwingung. Die Schwingung des Rechteckgenerators dient somit als Trägerfrequenz und wird also vom Differenzstrom im Puls-Pausenverhältnis moduliert.

In bekannter Weise kann sich die Höhe der Ausgangsspannung von Komparatoren oder Operationsverstärkern in Abhängigkeit der Umgebungstemperatur oder aufgrund von Eigenerwärmung unvorteilhaft ändern. Zudem ändern sich die beiden Polaritäten der Ausgangsspannung nicht gleichmäßig bei Veränderungen der Temperatur bezogen auf die Funktionalität der vorliegenden Schaltung in sehr unvorteilhafter Weise. Wie bereits weiter oben erwähnt, ergibt sich ein Puls-Pausenverhältnis der Rechteckausgangsspannung der Schwingschaltung 22 von 1:1, wenn der Stromwandler 1 nicht von einem Differenzstrom durchflutet wird. Ändern sich jedoch die Amplituden der Ausgangsspannung beider Polaritäten bei Temperaturänderung nicht im gleichen Maße, so ist das Flächenverhältnis beider Halbwellen des Rechteckgenerators nicht mehr gleich und somit ist das Puls-Pausenverhältnis nicht mehr 1:1. Von den nachfolgenden Auswerteschaltungen wird dieses Missverhältnis als DC-Offset in unvorteilhafter Weise als glatter Gleichfehlerstrom interpretiert. Insbesondere wenn es erwünscht ist, dass sehr kleine glatte Gleichfehlerströme erfasst werden sollen, besteht die Möglichkeit, dass der unerwünschte DC-Offset ähnliche Größenordnungen annimmt, wie der zu erfassende glatte Gleichfehlerstrom.

In vorteilhafter Weise weist die erfindungsgemäße Ausgestaltung der Schwingschaltung 22 daher zur Erfassung sehr kleiner glatter Gleichfehlerströme zwei Operationsverstärker oder Komparatoren U1, U2 sowie zwei Sekundärwicklungen N13, N14 mit bevorzugt gleicher Windungszahl des Stromwandlers 1 auf. In einer besonders vorteilhaften Ausgestaltung sind beide Komparatoren bzw. beide Operationsverstärker U1, U2 in einem Gehäuse angeordnet, so dass sich Änderungen der Temperatur im gleichen Maße auf U1 und U2 auswirken. Ändert sich nun die Temperatur und damit auch die Ausgangsspannung von U1 und U2, die in einer als Brückenschaltung ausgeführten Schaltung angeordnet sind, so wirkt sich diese Änderung in vorteilhafter Weise im gleichen Maße auf beide Halbwellen der Rechteckschwingung aus. Da sich die Flächeninhalte der positiven und negativen Halbwelle der Rechteckschwingung nun gleichmäßig ändern, bleibt das Puls-Pausenverhältnis 1:1 und es entsteht kein unerwünschter DC-Offset. Dadurch lassen sich in vorteilhafter Weise auch sehr kleine glatte Gleichfehlerströme zuverlässig erfassen. Die Ausgangsspannungssignale von U1 und U2 können die Eingangsspannungssignale einer Differenzverstärkerschaltung U3 sein, deren Ausgang mit dem Eingang des Tiefpasses 23 verschaltet ist.
Fig. 3 zeigt ein Blockschaltbild der erfindungsgemäßen Vorrichtung zur Erfassung auch von glatten Gleichfehlerströmen ≤ 6 mA, wobei im Gegensatz zu Fig. 1 der Stromwandler 1 eine weitere Sekundärwicklung N14 aufweist. Die Sekundärwicklungen N13, N14 des Stromwandlers 1 bilden zusammen mit der in Fig. 2 näher erläuterten Schaltung 22 eine modulierende Schwingschaltung, welche zur zuverlässigen Erfassung sehr kleiner glatter Gleichfehlerströme geeignet ist. Eine mit der Schaltung 22 verschaltete Überwachungsschaltung 30 ist vorgesehen, deren Ausgang auf den Eingang der Komparatorsschaltung 27 wirkt. Wenn die als Rechteckgenerator ausgebildete modulierende Schwingschaltung unzulässige Zustände, z.B. einen Schwingungsstillstand einnimmt, erfolgt eine sofortige Abschaltung der Vorrichtung. Eine Beschreibung der weiteren Bauteile der Vorrichtung kann dem Text zu Fig. 1 entnommen werden.

In Fig. 4 ist im Vergleich zu Fig. 3 ein verändertes und vereinfachtes Ausführungsbeispiel der erfindungsgemäßen Vorrichtung zur Erfassung auch von glatten Gleichfehlerströmen ≤ 6 mA aufgeführt, wobei die Erfassung von glatten Gleichfehlerströmen ebenfalls hilfsspannungsabhängig erfolgt und die Erfassung von Differenzströmen mit Frequenzen > 0 Hz hilfsspannungsunabhängig erfolgt.

Im Vergleich zum zuvor aufgeführten Ausführungsbeispiel nach Fig. 3 weist das in Fig. 4 aufgeführte Ausführungsbeispiel in vorteilhafter Weise weniger Baugruppen und somit weniger Bauteile auf. Die elektronische Schaltung 220 zur Erfassung von Wechselfehlerströmen funktioniert hilfsspannungsunabhängig und kann sowohl sehr niederfrequente Wechselfehlerströme (z.B. der Netzfrequenz mit 50 bzw. 60 Hz und auch darunter) als auch sehr hochfrequente Fehlerströme (z.B. 100 kHz) erfassen. Dadurch kann der Unterspannungsdetektor 214 mit Schaltkontakt 28 sowie auch der Summierverstärker 24 entfallen.

Zur Erfassung auch von sehr kleinen glatten Gleichfehlerströmen ist die in Fig. 2 näher erläuterte Schaltung 22 mit 2 Sekundärwicklungen N13, N14 des Stromwandlers 1 vorgesehen. Zudem ist eine Überwachungsschaltung 30 vorgesehen, deren Ausgang auf den Speicherkondensator 222 einer Energiespeicherschaltung 220 wirkt, wenn die als Rechteckgenerator ausgebildete modulierende Schwingschaltung 22 unzulässige Zustände, z.B. einen Schwingungsstillstand einnimmt, so dass eine sofortige Abschaltung der Vorrichtung erfolgt. Im der Schaltung 22 nachfolgenden Leitungsweg ist ein Tiefpassfilter 23 und eine nachfolgende Auswerteschaltung 216 angeordnet, welche aus einem Zweiweggleichrichter 25, einem Tiefpassfilter 26 und einer Komparatorschaltung 27 besteht. Die Komparatorschaltung 27 kann aus mehreren Komparatoren mit Tiefpassfiltern bestehen, damit die Vorrichtung nicht bei kurzen transienten Differenzströmen anspricht. Die Komparatorschaltung 27 ist ausgangsseitig direkt mit dem Speicherkondensator 222 der Energiespeicherschaltung 220 verknüpft, sodass bei Vorlage eines unzulässig hohen glatten Gleichfehlerstromes eine sofortige Aufladung des Speicherkondensators 222 erfolgt, wodurch eine Abschaltung der Vorrichtung bewirkt wird. Eine Netzteilschaltung 215, welche aus den elektrischen Leitern 21 gespeist wird, versorgt die hilfsspannungsabhängigen Baugruppen 22, 23, 25, 26, 27 und 30 mit einer erforderlichen Gleichspannung.

Es ist vorgesehen, dass das eine Phasendrehung des über den Leitungsweg geführten Stromes um etwa 180 DEG bewirkende Koppelglied 29 in einfachster Weise als ohmscher Widerstand 210 ausgebildet ist, welcher somit auch Bestandteil des Gegenkopplungsstromkreises 217 ist. Der Widerstand 210 ist erfindungsgemäß gleichzeitig in vorteilhafter Weise auch Bestandteil einer Energiespeicherschaltung 220 zur Erfassung von Differenzströmen mit Frequenzen > 0 Hz. Die Energiespeicherschaltung 220 besteht aus dem Widerstand 210, welcher mit einer spannungsvervielfachenden Schaltung 221 eingangsseitig verschaltet ist, bzw. somit auch als Bestandteil der spannungsvervielfachenden Schaltung 221 betrachtet werden kann, sowie aus einem Speicherkondensator 222 und einer Komparatorschaltung 223. Die Höhe der Ladespannung des Speicherkondensators 222 ist ein Maß für die Höhe des erfassten Differenzstromes mit Frequenzen > 0 Hz. Die Komparatorschaltung 223 ist mit einem Auslöserelais 213 verknüpft, das bei Vorlage eines unzulässig hohen Differenzstromes bewirkt, dass ein mechanisches Schaltschloss 218 die in den zu überwachenden Leitungen 21 angeordneten Schaltkontakte 219 öffnet, sodass der Stromfluss unterbrochen wird. Die Komparatorschaltung 223 kann aus mehreren Komparatoren mit Tiefpassfiltern bestehen, damit die Vorrichtung nicht bei kurzen transienten Differenzströmen anspricht.

Je nach Ausführung der Energiespeicherschaltung 220 kann die Vorrichtung zur breitbandigen Erfassung von Differenzströmen bis beispielsweise 100 kHz ausgelegt sein oder aber auch nur zur Erfassung von Wechsel- und Pulsfehlerströmen der Netzfrequenz. Zudem kann das Ausgangssignal der Komparatorschaltung 223 aus der erfindungsgemäßen Vorrichtung herausgeführt werden, so dass dieses Signal anderen elektrischen Betriebsmitteln bereitgestellt werden kann. Beispielsweise kann eine Steuereinheit eines elektrischen Betriebsmittels (z.B. eines Frequenzumrichters) dann eine Abschaltung des Betriebsmittels bewirken.

## Patentansprüche

1. Vorrichtung zum Erfassen von elektrischen Differenzströmen, insbesondere von Mischströmen aus glattem Gleichstrom und Wechselströmen, umfassend wenigstens zwei Leiter (21) für zu überwachende Lastströme und umfassend eine als Rechteckgenerator ausgebildete Schwingschaltung welche einen Stromwandler (1) und zumindest zwei Sekundärwicklungen (N13,N14) aufweist, wobei die Leiter durch den Stromwandler geführt sind, **dadurch gekennzeichnet,**
**dass** die Sekundärwicklungen (N13, N14) des Stromwandlers (1) mit zumindest einem ohmschen Widerstand (R5) elektrisch in Reihe verschaltet sind, dass die Schwingschaltung (22) zwei Operationsverstärker (U1, U2) aufweist, welche mit jeweils einer Sekundärwicklung (N13, N14) verschaltet sind und dass die Ausgänge der Operationsverstärker (U1, U2) mit den Eingängen einer Differenzverstärkerschaltung (U3) verschaltet sind.

2. Vorrichtung nach Anspruch 1, **dadurch gekennzeichnet, dass** sie für glatte Gleichfehlerströme eine Auslöseschwelle ≤ 6 mA hat.

3. Vorrichtung nach Anspruch 1 oder 2, **dadurch gekennzeichnet, dass** die zu überwachenden Leiter (21) durch wenigstens einen weiteren magnetischen Stromwandler (7) geführt sind und dass der zweite Stromwandler (7) mit dem ersten Stromwandler (1) elektrisch leitend verschaltet ist, wobei auf dem Leitungsweg zwischen den Stromwandlern (1, 7) ein eine Phasendrehung des über den Leitungsweg geführten Stromes um etwa 180 DEG bewirkendes Koppelglied (29) angeordnet ist, das als Hochpass ausgebildet ist.

4. Vorrichtung nach einem der vorhergehenden Ansprüche, **dadurch gekennzeichnet, dass** die beiden Operationsverstärker (U1, U2) in einem Gehäuse angeordnet sind.

5. Vorrichtung nach einem der vorhergehenden Ansprüche, **dadurch gekennzeichnet, dass** zur Überwachung der Schwingschaltung (22) eine Überwachungsschaltung (30) vorgesehen ist.

6. Vorrichtung nach einem der vorhergehenden Ansprüche, **dadurch gekennzeichnet, dass** die Erfassung und Auswertung von Differenzströmen mit Frequenzen > 0 Hz hilfsspannungsunabhängig erfolgt.

7. Vorrichtung nach Anspruch 6, **dadurch gekennzeichnet, dass** hilfspannungsunabhängig nur Wechselfehlerströme und pulsierende Gleichfehlerströme der Netzfrequenz erfassbar sind.

8. Vorrichtung nach Anspruch 6 oder 7, **dadurch gekennzeichnet, dass** hilfsspannungsunabhängig Wechselfehlerströme und pulsierende Gleichfehlerströme der Netzfrequenz sowie Wechselfehlerströme mit Frequenzen > 0 Hz erfasst werden.

9. Vorrichtung nach einem der Ansprüche 3 bis 8, **dadurch gekennzeichnet, dass** das eine Phasendrehung des über den Leitungsweg geführten Stromes um etwa 180 DEG bewirkende Koppelglied (29) als elektrischer Widerstand (210) ausgeführt ist.

10. Vorrichtung nach Anspruch 9, **dadurch gekennzeichnet, dass** der das Koppelglied (29) ausbildende Widerstand (210) zugleich Bestandteil einer Energiespeicherschaltung (220) ist.

11. Vorrichtung nach einem der vorhergehenden Ansprüche, **dadurch gekennzeichnet, dass** alle Bauteile der Vorrichtung in einem Gehäuse angeordnet sind.

12. Vorrichtung nach einem der vorhergehenden Ansprüche 1 bis 10, **dadurch gekennzeichnet, dass** die Bauteile der Vorrichtung in verschiedenen Gehäusen angeordnet sind.

13. Vorrichtung nach einem der vorhergehenden Ansprüche, **dadurch gekennzeichnet, dass** das Ausgangssignal der Komparatorschaltung (223) herausgeführt wird.

## Claims

1. A device for detecting electrical differential currents, in particular of mixed currents of smoothed direct current and alternating currents, comprising at least two conductors (21) for load currents to be monitored and comprising an oscillatory circuit designed as a square wave generator, which has a current converter (1) and at least two secondary windings (N13, N14), wherein the conductors are led through the current converter,
**characterised in that**
the secondary windings (N13, N14) of the current converter (1) are electrically connected in series with at least one ohmic resistance (R5), **in that** the oscillatory circuit (22) has two operational amplifiers (U1, U2), which are electrically connected to respective secondary windings (N13, N14), and **in that** the outputs of the operational amplifiers (U1, U2) are electrically connected with the inputs of a differential amplifier circuit (U3).

2. The device in accordance with claim 1, **characterised in that** for smoothed DC residual currents it has a trigger threshold of ≤ 6 mA.

3. The device in accordance with claim 1 or 2,
**characterised in that** the conductors (21) to be monitored are led through at least one further magnetic current converter (7), and **in that** the second current converter (7) is connected in an electrically conducting manner with the first current converter (1), wherein a coupling element (29) is arranged on the conducting path between the current converters (1, 7), effecting a phase shift of the current fed along the conducting path by about 180° ; the coupling element (29) is designed as a high-pass filter.

4. The device in accordance with one of the preceding claims, **characterised in that** the two operational amplifiers (U1, U2) are arranged in one housing.

5. The device in accordance with one of the preceding claims, **characterised in that** a monitoring circuit (30) is provided for purposes of monitoring the oscillatory circuit (22).

6. The device in accordance with one of the preceding claims, **characterised in that** the detection and evaluation of differential currents with frequencies > 0 Hz takes place independently of auxiliary voltages.

7. The device in accordance with claim 6, **characterised in that** only AC residual currents and pulsating DC residual currents at the supply frequency can be detected independently of auxiliary voltages.

8. The device in accordance with claim 6 or 7,
**characterised in that** AC residual currents and pulsating DC residual currents at the supply frequency, together with AC residual currents with frequencies > 0 Hz, are detected independently of auxiliary voltages.

9. The device in accordance with one of the claims 3 to 8, **characterised in that** the coupling element (29) effecting a phase shift of the current fed along the conducting path by about 180° is embodied as an electrical resistance (210).

10. The device in accordance with claim 9, **characterised in that** the resistance (210) forming the coupling element (29) is at the same time a component of an energy storage circuit (220).

11. The device in accordance with one of the preceding claims, **characterised in that** all components of the device are arranged in one housing.

12. The device in accordance with one of the preceding claims 1 to 10, **characterised in that** the components of the device are arranged in various housings.

13. The device in accordance with one of the preceding claims, **characterised in that** the output signal of the comparator circuit (223) is led out.

## Revendications

1. Dispositif pour la détection de courants électriques différentiels, en particulier de courants ondulatoires à courant continu lisse et courants alternatifs, comprenant au moins deux conducteurs (21) pour des courants de charge à surveiller et comprenant un circuit oscillant réalisé en tant que générateur de signaux rectangulaires qui présente un transformateur de courant (1) et au moins deux enroulements secondaires (N13, N14), dans lequel on fait passer les conducteurs à travers le transformateur de courant, **caractérisé en ce que**
les enroulements secondaires (N13, N14) du transformateur de courant (1) sont connectés électriquement en série avec au moins une résistance ohmique (R5), **en ce que** le circuit oscillant (22) présente deux amplificateurs opérationnels (U1, U2) qui sont respectivement connectés à un enroulement secondaire (N13, N14) et **en ce que** les sorties des amplificateurs opérationnels (U1, U2) sont connectées aux entrées d'un circuit amplificateur différentiel (U3).

2. Dispositif selon la revendication 1, **caractérisé en ce que**, pour des courants de défaut continus lisses, il possède un seuil de déclenchement ≤ 6 mA.

3. Dispositif selon la revendication 1 ou 2, **caractérisé en ce que** l'on fait passer les conducteurs (21) à surveiller à travers au moins un autre transformateur de courant magnétique (7) et **en ce que** le deuxième transformateur de courant (7) est connecté de manière électroconductrice au premier transformateur de courant (1), dans lequel, dans le chemin de conduction entre les transformateurs de courant (1, 7) est disposé un organe de couplage (29) produisant une rotation de phase du courant acheminé via le chemin de conduction de près de 180 DEG, lequel organe est réalisé en tant que passe-haut.

4. Dispositif selon l'une des revendications précédentes, **caractérisé en ce que** les deux amplificateurs opérationnels (U1, U2) sont disposés dans un boîtier.

5. Dispositif selon l'une des revendications précédentes, **caractérisé en ce que**, pour la surveillance du circuit oscillant (22), on prévoit un circuit de surveillance (30).

6. Dispositif selon l'une des revendications précédentes, **caractérisé en ce que** la détection et l'évaluation de courants différentiels s'effectuent indépendamment d'une tension auxiliaire avec des fréquences > 0 Hz.

7. Dispositif selon la revendication 6, **caractérisé en ce qu'**il est seulement possible de détecter, indépendamment d'une tension auxiliaire, des courants de défaut alternatifs et des courants de défaut continus pulsatoires de la fréquence du secteur.

8. Dispositif selon la revendication 6 ou 7, **caractérisé en ce que** l'on détecte, indépendamment d'une tension auxiliaire, des courants de défaut alternatifs et des courants de défaut continus pulsatoires de la fréquence du secteur ainsi que des courants de défaut alternatifs avec des fréquences > 0 Hz.

9. Dispositif selon l'une des revendications 3 à 8, **caractérisé en ce que** l'organe de couplage (29) produisant une rotation de phase du courant acheminé via le chemin de conduction de près de 180 DEG est réalisé en tant que résistance électrique (210).

10. Dispositif selon la revendication 9, **caractérisé en ce que** la résistance (210) formant l'organe de couplage (29) est simultanément un élément constitutif d'un circuit d'accumulation d'énergie (220).

11. Dispositif selon l'une des revendications précédentes, **caractérisé en ce que** tous les composants du dispositif sont disposés dans un boîtier.

12. Dispositif selon l'une des revendications 1 à 10 précédentes, **caractérisé en ce que** les composants du dispositif sont disposés dans différents boîtiers.

13. Dispositif selon l'une des revendications précédentes, **caractérisé en ce que** l'on fait sortir le signal de sortie du circuit comparateur (223).
